# EUROPÄISCHE PATENTSCHRIFT

(11) **EP 3 017 312 B1**
(45) Veröffentlichungstag und Bekanntmachung des Hinweises auf die Patenterteilung: **08.03.2017**
(21) Anmeldenummer: 14734396.6
(22) Anmeldetag: 01.07.2014
(51) Int. Cl.: G01R 33/563, G01R 33/56

(54) **BILDGEBUNGSVERFAHREN FÜR KERNSPINTOMOGRAPHISCHE DIFFUSIONSDATEN, COMPUTERPROGRAMMPRODUKT UND BILDGEBUNGSVORRICHTUNG**
IMAGING METHOD FOR MAGNETIC RESONANCE TOMOGRAPHY DIFFUSION-WEIGHTED DATA, COMPUTER PROGRAM PRODUCT, AND IMAGING APPARATUS
PROCÉDÉ D'IMAGERIE POUR DONNÉES DE DIFFUSION D'IMAGERIE À RÉSONANCE TOMOGRAPHIQUE, PRODUIT PROGRAMME D'ORDINATEUR ET DISPOSITIF D'IMAGERIE

(30) Priorität: 03.07.2013 DE 102013213010
(43) Veröffentlichungstag der Anmeldung: 11.05.2016
(73) Patentinhaber: Fachhochschule Stralsund, 18435 Stralsund (DE)
(72) Erfinder: EHRICKE, Hans-Heino, 18435 Stralsund (DE); OTTO, Kay Michael, 18445 Prohn (DE); HÖLLER, Mark, 18439 Stralsund (DE)
(74) Vertreter: Seemann & Partner Patentanwälte mbB
(86) Internationale Anmeldenummer: PCT/EP2014/001794
(87) Internationale Veröffentlichungsnummer: WO 2015/000583

(56) Entgegenhaltungen:
- HÖLLER M. ET AL.: "Visualization of High Angular Resolution Diffusion MRI Data with Color-Coded LIC-Maps", Online LECTURE NOTES IN INFORMATICS, LNI PROCEEDINGS 2012, 2012, Seiten 1112-1124, XP002730246, Germany Gefunden im Internet: URL:http://subs.emis.de/LNI/Proceedings/Pr oceedings208/1112.pdf [gefunden am 2014-09-25]
- THOMAS SCHULTZ ET AL: "Superquadric Glyphs for Symmetric Second-Order Tensors", IEEE TRANSACTIONS ON VISUALIZATION AND COMPUTER GRAPHICS, IEEE SERVICE CENTER, LOS ALAMITOS, CA, US, Bd. 16, Nr. 6, 1. November 2010 (2010-11-01), Seiten 1595-1604, XP011327243, ISSN: 1077-2626, DOI: 10.1109/TVCG.2010.199
- GORDON KINDLMANN ET AL: "Diffusion Tensor Visualization with Glyph Packing", IEEE TRANSACTIONS ON VISUALIZATION AND COMPUTER GRAPHICS, IEEE SERVICE CENTER, LOS ALAMITOS, CA, US, Bd. 12, Nr. 5, 1. September 2006 (2006-09-01), Seiten 1329-1336, XP011150928, ISSN: 1077-2626, DOI: 10.1109/TVCG.2006.134
- VOS S.B. ET AL.: "Visualizing fiber pathways in regions with complex white matter architecture", INTERNATIONAL SOCIETY FOR MAGNETIC RESONANCE IN MEDICINE, 20TH ANNUAL MEETING PROCEEDINGS, 5. Mai 2012 (2012-05-05), Seite 1914, XP040624336, Australia

## Beschreibung

Die Erfindung betrifft ein LIC-basiertes Bildgebungsverfahren für kernspintomographische Diffusionsdaten, die in einem Diffusionsdaten-Vektorfeld mit einem dreidimensionalen Voxel-Raster vorliegen, wobei jedem Voxel ein Diffusionsprofil mit Richtungsvektoren anisotroper Diffusion mit Richtungen zugeordnet ist, in denen die Diffusionsdaten lokal jeweils ein anisotropes Verhalten aufweisen, und eine Bildgebungsvorrichtung.

Bei der diffusionsgewichteten Kernspin-Tomographie wird für jedes Raumelement (Voxel) durch Schalten von Gradienten in mehrere unterschiedliche Raumrichtungen das Ausmaß der Diffusion von Wassermolekülen in lebendem Gewebe für die jeweiligen Richtungen gemessen. Prinzipiell ist die Diffusion isotrop, also ungerichtet. Beispielsweise im Bereich von Nervenfasern erfolgt jedoch eine gerichtete (anisotrope) Diffusion, bedingt durch die Kanalisierung durch die Myelinscheiden der Nervenfasern. Für Raumrichtungen, die dem Verlauf von Nervenfasern entsprechen, ergibt sich ein hohes Ausmaß an Anisotropie durch die Diffusion, was sich bei der Datengewinnung mittels diffusionsgewichteter Kernspin-Tomographie in der Regel in einer erkennbaren Signalabschwächung niederschlägt.

Bei der diffusionsgewichteten Kernspin-Tomographie wird ein Körpervolumen durch ein regelmäßiges, dreidimensionales Raster von Voxeln erfasst. Für jedes Voxel werden Signale für unterschiedliche Raumrichtungen aufgenommen und gespeichert. Aufgrund der beschränkten räumlichen Auflösung des Messverfahrens enthalten Voxel häufig Nervenfasern, die in unterschiedliche Richtungen verlaufen, beispielsweise im Bereich von Kreuzungen und Verzweigungen. Aus diesem Grund wurde die Messtechnik dahingehend weiterentwickelt, dass pro Voxel viele Raumrichtungen - typischerweise über 50 - untersucht werden. Die Messdaten werden vor der weiteren Verarbeitung üblicherweise dergestalt transformiert, dass sich pro Voxel ein Diffusionsprofil ergibt.

Eine Möglichkeit, dieses Diffusionsprofil zu erfassen, ist die Berechnung eines Diffusionstensors, der durch drei orthogonal zueinander stehende Richtungsvektoren aufgespannt wird (Diffusion Tensor Imaging, DTI). Bei diesem Modell zeigt der Hauptrichtungsvektor in die Richtung der stärksten Diffusion. Allerdings bildet das Modell bei Vorliegen mehrerer anisotroper Richtungen in einem Voxel das Diffusionsprofil nur ungenügend ab.

Daher wurden modellfreie Darstellungen des Diffusionsprofils vorgeschlagen, die das Diffusionsprofil mit einer diskreten Richtungsfunktion beschreiben. Diese enthält für diskrete Raumrichtungen jeweils mindestens eine Maßzahl (Skalar), die dem Ausmaß der Wasserdiffusion in diese Richtung entspricht. Dabei kann eine Raumrichtung durch einen Richtungsvektor mit x-y-z-Koordinaten in einem kartesischen XYZ-Raumkoordinatensystem oder mit Inklinations-/Deklinationswinkeln in einem sphärischen Koordinatensystem beschrieben werden.

Beispielsweise wird beim Q-Ball Imaging durch Anwendung der Funk-Radon-Transformation eine so genannte Orientation-Distribution-Function (ODF) erzeugt. Dabei werden auf einer Kugeloberfläche mit Mittepunkt im Voxelzentrum Funktionswerte berechnet, die den Betrag der Diffusion in die durch den Vektor vom Zentrum zum Oberflächenpunkt definierte Richtung repräsentieren.

In J. D. Tournier et al., "Direct estimation of the fiber orientation density function from diffusion-weighted MRI data using spherical deconvolution", Neurolmage 23 (2004) 1176 - 1185, ist eine andere Möglichkeit der Beschreibung des lokalen Diffusionsprofils beschrieben. Die so genannte Fiber Orientation Distribution Function (FOD) wird aus den Messdaten durch Anwendung einer sphärischen Entfaltung (Spherical Deconvolution) gewonnen, also einer Transformation, die auf Kugelflächenfunktionen basiert. Die FOD zeigt gegenüber der ODF ein deutlich schärferes Diffusionsprofil, wodurch die Richtungen anisotroper Diffusion und somit mögliche Verläufe von Nervenfasern leichter zu bestimmen sind, beispielsweise durch die Suche von Maxima in der FOD. Die FOD kann als Oberflächen-Objekt repräsentiert werden, wobei ausgehend von einem Zentrum in jede der Raumrichtungen ein Oberflächenpunkt bestimmt wird und sich die Distanz zum Zentrum aus dem für die betreffende Raumrichtung gespeicherten FOD-Wert ergibt.

Für die Datenanalyse sowie die weitere Verarbeitung der Daten, z.B. für die Rekonstruktion von Faserverläufen durch Fasertracking, wird die diskrete Richtungsfunktion eines Voxels dergestalt analysiert, dass Raumrichtungen gesucht werden, in denen die Wasserdiffusion ein relevant hohes (anisotropes) Ausmaß aufweist. Dies kann anhand von Maxima bzw. Minima des Funktionsverlaufs untersucht werden. Fasertrackingverfahren verfolgen ausgehend von Startpunkten (Seeds) die lokal vorliegenden Richtungsinformationen mit einem iterativen Algorithmus und setzen die verfolgten Raumpunkte zu einer durchgängigen Linie, die eine Nervenfaser repräsentiert, zusammen. Das Verfahren kann mathematisch als Integration durch das Vektorfeld der Richtungsinformationen aufgefasst werden. Die erzeugten Linien sind durch eine Folge von Punkten im dreidimensionalen Raum definiert und können durch Verfahren der Computergraphik als 3D Darstellungen z.B. in Form von Strömungslinien (Streamlines) oder Strömungsröhren (Streamtubes) visualisiert werden.

Die Parametrisierung von Fasertrackingverfahren ist schwierig und muss an die gegebene Aufgabenstellung und die vorliegenden Messdaten angepasst werden. Beispielsweise sind Abbruchbedingungen zu definieren und es müssen Seeds platziert werden sowie bei einigen Anwendungen Zielregionen, in denen die Integrationslinien ankommen sollen. Das Ergebnis ist wesentlich von der Wahl der durch den Anwender definierten Parameter abhängig. Zudem können bei der Linienverfolgung Fehler auftreten, die dazu führen, dass verfolgte Linien keine anatomische Entsprechung als Faserbahn haben oder dass Teile von Faserbahnen nicht dargestellt werden. Diese Fehler sind in den erzeugten 3D Darstellungen nicht unmittelbar erkennbar, so dass es bei der Betrachtung zu Fehlinterpretationen kommen kann.

Fasertracking-Verfahren interpretieren die vorliegenden Messdaten weitgehend automatisch. Beispielsweise wird in jedem Iterationsschritt durch den Algorithmus eine Entscheidung getroffen, in welche Richtung weitergegangen wird. Ist diese Entscheidung aufgrund von Defiziten der Messdaten wie z.B. Signalrauschen nicht richtig oder nicht ganz richtig, so wird in eine falsche Richtung weitergegangen. Zudem können sich Fehlentscheidungen aufsummieren (Fehlerfortpflanzung, Error Propagation), wodurch Linien entstehen, die keine anatomische Entsprechung haben.

In dem Patent DE 10 2009 036 969 B3 der Anmelderin ist ein Verfahren beschrieben, in dem das Fasertracking durch eine orts- und richtungsabhängige diskrete Diffusionskontrastfunktion unter Verwendung von Teilräumen unterstützt wird, mittels der die Diffusionsdaten lokal einer Rauschunterdrückung und Richtungskontrastverstärkung unterworfen werden, um die Trackinggenauigkeit zu erhöhen. Die Definition eines Teilraums als Auswahlkriterium für benachbarte Raumelemente, aus denen Messdaten oder Funktionswerte zur Rauschunterdrückung und Kontrastverstärkung verwendet werden, verleiht dem Verfahren eine erhöhte Richtungsselektivität und verwendet den Umstand, dass beispielsweise Nervenfasern im Körper sich im Allgemeinen in einer Richtung erstrecken und einen Krümmungsradius besitzen, der im Allgemeinen größer ist als die Auflösung der kernspintomographischen Diffusionsmessungen, während die Ausdehnung von Nervenfasern transversal zu ihrem Verlauf an oder unter der Auflösungsgrenze liegt. Diese Auswahl von für eine Glättung und Kontrastverstärkung benutzten Messdaten aus einem um die jeweils betrachtete Raumrichtung angeordneten und ausgerichteten Teilraum verstärkt somit ohne Modellannahmen und auf einfache Weise die in den Rohdaten enthaltene, verrauschte Information über die Position und Verlaufsrichtung von Nervenfasern.

Nachteilig ist bei bekannten Fasertracking-Verfahren auch, dass die Visualisierung von Fasern in Relation zu anatomischen Details, wie sie üblicherweise durch Schnittbilder der Kernspin-Tomographie mit T1- oder T2-Wichtung oder der Computer-Tomographie dargestellt werden, auf der Basis von berechneten Faserbahnlinien im Raum nur schwer gelingt, da hierbei die dreidimensionalen Objekte der Faserbahnen mit zweidimensionalen Schnittbildern kombiniert werden müssen. Durch Einblendung von Schnittbildern in 3D Darstellungen von Faserbahnen wird die räumliche Beziehung anatomischer Strukturen zu Faserbahnen nur ungenügend visualisiert.

Als Alternative zu den Fasertrackingverfahren wurde von einigen Autoren die Anwendung der Linienintegralfaltung (Line Integral Convolution, LIC) auf Diffusionsdaten vorgeschlagen. Beispiele hierfür sind B. Wünsche und R. Lobb, "The 3D Visualization of Brain Anatomy from Diffusion-Weighted Magnetic Resonance Imaging Data", Proceedings of GRAPHITE 2004, pp. 74-83, ACM-Press 2004, G. Kindlmann et al., "Strategies for Direct Volume Rendering of Diffusion Tensor Fields", IEEE Trans. Vis. Comput. Graph. 6(2): 124 - 138, 2000, und T. McGraw et al., "Line Integral Convolution for Visualization of Fiber Tract Maps from DTI", MICCAI '02 Proceedings of the 5th International Conference on Medical Image Computing and Computer-Assisted Intervention-Part II, pp. 615-622.

Beim LIC-Verfahren wird einem Rauschmuster, das in der einfachsten Form aus weißem Rauschen bestehen kann, die Struktur eines Vektorfeldes aufgeprägt. Für jeden Punkt des Rauschbildes wird dabei zunächst eine Integrallinie berechnet, indem die Vektorrichtungen im Vektorfeld ausgehend von dem betreffenden Punkt über eine gewisse Distanz iterativ in Vektorrichtung und in Gegenrichtung verfolgt werden. Die Signalwerte dieser auf der Integrallinie liegenden Punkte werden dann gemittelt und im Ausgabebild als Ergebnis gespeichert. Angewendet auf kernspintomographische Diffusionsdaten wird im Ausgabebild die Faserstruktur sichtbar. Dabei ist es nicht notwendig, die Integrallinien über längere Strecken zu verfolgen, sondern es reicht aus, die Verfolgung auf wenige Iterationsschritte und somit auf eine kleine Umgebung um den Startpunkt zu begrenzen. Dies hat den Vorteil, dass das Problem der Fehlerfortpflanzung hier keine Rolle spielt und somit die Gefahr von Fehlinterpretationen deutlich geringer ist. Allerdings haben die sich im Ergebnisbild abzeichnenden Faserstrukturen nur einen vergleichsweise geringen Kontrast zum Hintergrundrauschen, wodurch die Wahrnehmung insbesondere kleinerer Faserstrukturen oder Faserstrukturen im Bereich von Faserbahn-Kreuzungen und -Verzweigungen erschwert wird.

In M. Höller et al., "Visualization of High Angular Resolution Diffusion MRI Data with Color-Coded LIC-Maps", Lecture Noters in Informatics, LNI Proceedings 2012, Seiten 1112 bis 1124, wird die Visualisierung lokaler Diffusionsprofile in Voxeln von Diffusions-MRI-Aufnahmen unter Verwendung einer glyphenbasierten Technik beschrieben. Es werden ellipsoide oder superquadratische Tensor-Glyphen verwendet. Zur Überbrückung von lokalen und globalen Darstellungen wird Linienintegralfaltung (Line Integral Convolution, LIR) in mehreren Richtungen eingesetzt und ein Mehrkern-Ansatz gewählt.

Der Erfindung liegt die Aufgabe zugrunde, ein Verfahren zur Verarbeitung und Visualisierung kernspintomographischer Diffusionsdaten zur Verfügung zu stellen, das die Gefahr von Fehlinterpretationen durch den Betrachter reduziert und Faserstrukturen auch im Bereich von Kreuzungen, Verzweigungen und Berührungen von Faserbahnen mit hohem Kontrast und guter Wahrnehmbarkeit darstellt. Zudem soll eine Visualisierung von Faserstrukturen in Relation zu anatomischen Details, wie sie üblicherweise mit anatomischen Schnittbildern der Kernspin-Tomographie oder der Computer-Tomographie dargestellt werden, ermöglicht werden.

Diese der Erfindung zugrundeliegende Aufgabe wird durch ein LICbasiertes Bildgebungsverfahren für kernspintomographische Diffusionsdaten gelöst, die in einem Diffusionsdaten-Vektorfeld mit einem dreidimensionalen Voxel-Raster vorliegen, wobei jedem Voxel ein Diffusionsprofil mit Richtungsvektoren anisotroper Diffusion mit Richtungen zugeordnet ist, in denen die Diffusionsdaten lokal jeweils ein anisotropes Verhalten aufweisen, mit den folgenden Schritten:
a) es wird ein dreidimensionales Musterfeld mit unterschiedlichen Signalwerten erzeugt, dessen Voxel-Raster wenigstens die gleiche oder eine höhere Auflösung als das Voxel-Raster der Diffusionsdaten aufweist,
b) für jedes Voxel eines dreidimensionalen Ausgabefeldes, dessen Voxel-Raster dem Voxel-Raster des Musterfeldes entspricht, wird wenigstens eine Integrallinie berechnet, indem mittels eines Fasertracking-Algorithmus Richtungsvektoren anisotroper Diffusion ausgehend von dem jeweiligen Voxel über eine vorbestimmte Distanz in Vektorrichtung und Vektorgegenrichtung lokal verfolgt werden,
c) die Signalwerte des Musterfeldes der auf der Integrallinie liegenden Punkte werden gewichtet aufsummiert und/oder gemittelt und der daraus resultierende Wert in einen entsprechenden Voxel des dreidimensionalen Ausgabefelds
   eingetragen,
das dadurch weiterentwickelt ist, dass im Schritt a) das Musterfeld mit Glyphenobjekten gefüllt wird, die jeweils Längserstreckungen in eine oder mehrere Richtungen aufweisen, wobei die Richtungen der Längserstreckungen der Glyphenobjekte den Richtungen der Richtungsvektoren der Diffusionsprofile der umliegenden Voxel des Diffusionsdaten-Vektorfelds entsprechen und/oder daraus interpoliert sind.

Die Erfindung beruht somit auf einem LIC-Algorithmus, bei dem als Eingabemuster ein aus wenigstens teilweise multidirektionalen Glyphen bestehendes Muster verwendet wird, wobei das Glyphenmuster aus den gemessenen Diffusionsdaten oder davon abgeleiteten Daten, die für jedes Voxel ein Diffusionsprofil repräsentieren, berechnet wird. Unter einem Glyphen oder Glyphenobjekt wird ein zwei- oder dreidimensionales Objekt verstanden, dessen Form und Platzierung im Raum von Eigenschaften der gemessenen Diffusionsdaten abhängig ist. Multidirektionale Glyphen oder Glyphenobjekte sind solche, die ein oder mehrere anisotrope Diffusionsrichtungen repräsentieren. Glyphen oder Glyphenobjekte können je nach Ausführung unterschiedliche Formen annehmen, etwa die Form eines FOD-Oberflächenobjekts haben oder Formen, die aus der Überlagerung von mehreren Ellipsoiden oder mehreren Zylindern entstehen.

Die Verwendung entsprechender Glyphenobjekte führt dazu, dass das Musterfeld bereits Anlagen der Struktur des unterliegenden Diffusionsdaten-Vektorfeldes beinhaltet, die durch den LIC-Algorithmus geglättet und visualisiert wird. Da die Glyphen bereits Längserstreckungen in die Diffusionsrichtungen aufweisen, führt eine Linienintegralfaltung in dieselben Richtungen zu kontraststarken Linien. Bei einer Linienintegralfaltung in andere Richtungen verschwinden die Längserstreckungen der Glyphenobjekte im Hintergrund.

Vorzugsweise weisen das Musterfeld und das Ausgabefeld eine die Datenraster-Auflösung, insbesondere um das 10- oder mehrfache, insbesondere das 16- bis 24-fache, übersteigende Musterfeld-Auflösung auf. Damit wird es möglich, Strukturen auch unterhalb der eigentlichen Auflösung des Diffusionsdatenfeldes zu visualisieren.

Besonders bevorzugt ist es, dass die Glyphenobjekte kleiner, insbesondere halb so groß oder weniger, sind als die Größe von Voxeln des Diffusionsdaten-Vektorfelds. So lassen sich feine Strukturen deutlich identifizieren und darstellen.

Die Glyphenobjekte werden somit erfindungsgemäß nicht notwendigerweise in das Zentrum eines Voxels des Diffusionsdaten-Vektorfeldes gesetzt. Wenn sie an eine beliebige Stelle in einem Voxel oder zwischen zwei oder mehr Voxeln platziert werden, wird vorzugsweise ein Glyphenobjekt erzeugt, dessen Hauptrichtungen aus den umliegenden Voxeln interpoliert sind.

Das erfindungsgemäße Verfahren wird vorzugsweise verbessert, indem Schritt b) für jedes Voxel für die jeweils höchstrangige Richtung mit der jeweils stärksten lokalen Anisotropie in den Diffusionsdaten und zusätzlich auch für niederrangige Richtungen mit schwächeren lokalen Anisotropien in den Diffusionsdaten durchgeführt wird, sofern dem Voxel mehr als ein Richtungsvektor anisotroper Diffusion zugeordnet ist.

Als höchstrangige Richtung wird dabei diejenige Richtung eines Richtungsvektors anisotroper Diffusion mit der höchsten Anisotropie, also dem stärksten Wasserstoffdiffusionsfluss bezeichnet, niederrangige entsprechen schwächeren lokalen Anisotropien. Damit keine Artefakte entstehen, wird vorzugsweise ein Anisotropie-Schwellwert oberhalb des Rauschens der Diffusionsdaten gesetzt. Das so erweiterte Verfahren entspricht einem LIC-Verfahren mit Multi-Kernel oder Mehrfach-Kernen, da das Verfahren in verschiedene vorhandene Richtungen ausgeführt wird. Für Voxel, in denen nur eine Hauptrichtung der Richtungsvektoren anisotroper Diffusion überhaupt vorhanden ist und keine schwächeren Richtungen niederen Rangs, wird das LIC-Verfahren auch nur einmal durchgeführt. Aufgrund der anatomischen Gegebenheiten werden in lokaler Nachbarschaft Richtungen über mehrere Voxel erstreckt vorkommen. Bei benachbarten Voxeln können allerdings verschiedene Richtungen der Richtungsvektoren anisotroper Diffusion verschieden stark ausgeprägt sein. Aus diesem Grund wird das Verfahren nacheinander voxelweise für die jeweils erste, zweite und dritte usw. vorhandene Diffusionsrichtung durchgeführt.

Sofern einem Voxel mehr als ein Richtungsvektor zugeordnet ist, ist vorzugsweise vorgesehen, dass die Integrationsschritte in Schritt b) für die Integrallinien in den verschiedenen Richtungen
(1) kumulativ nacheinander erfolgen, wobei jede nachfolgende Integration in einer niederrangigen Richtung auf das im Ausgabefeld eingetragene Ergebnis der vorigen Integration erfolgt, oder
(2) unabhängig voneinander auf jeweils das gleiche anfängliche Musterfeld angewandt werden, wobei für die in das Ausgabefeld einzutragenden Werte die Ergebnisse für die unabhängig voneinander erfolgten Integrationsschritte gemittelt werden oder ein Maximalwert oder ein Minimalwert aus den Ergebnissen eingetragen wird.

Die erste Alternative entspricht einem modifizierten LIC-Verfahren, bei dem das Ergebnis eines ersten LIC-Schrittes mittels weiterer LIC-Schritte modifiziert wird. Die zweite Alternative wendet unabhängig voneinander die verschiedenen LIC-Schritte an. Bei dieser zweiten Alternative ist die Herausforderung, die verschiedenen Ergebnisse miteinander zu kombinieren. Dies ist bei der ersten Alternative automatisch bereits der Fall. In der zweiten Alternative ergibt sich der höchste Kontrast, wenn jeweils ein Maximalwert der verschiedenen Ergebnisse für jedes Voxel des Musterfeldes bzw. des resultierenden Feldes eingetragen wird. Es können auch gemeinsame Mehrrichtungs-Integrallinien erzeugt werden, so dass in einem Schritt über die Integrallinien in den verschiedenen Richtungen integriert wird.

Die Glyphenobjekte sind vorzugsweise zylindrisch, multizylindrisch oder mono- oder multidirektional doppelkeulenförmig. Die FOD-Objekte sind selbst im Wesentlichen doppelkeulenförmig. Dies trägt dem Umstand Rechnung, dass die diffusionsgewichteten MRT-Daten nicht zwischen einer Richtung und einer Gegenrichtung unterscheiden können, so dass zwar die allgemeine räumliche Orientierung des Stroms der Wasserstoffdiffusion bekannt ist, nicht jedoch die Eigenschaft, ob der Wasserstoffdiffusionsfluss in positiver oder in negativer Richtung erfolgt.

Vorzugsweise werden in Schritt a) die Glyphenobjekte im Musterfeld ausgehend von zufällig ausgewählten oder nach einem Schema bestimmten Seed-Positionen positioniert, wobei weitere Glyphenobjekte auf oder nahe bei Integrallinien positioniert werden, die von den Seed-Positionen ausgehen, wobei insbesondere ein Glyphenobjekt verworfen wird, wenn es mit einem bereits im Musterfeld positionierten anderen Glyphenobjekt überlappt. In der Regel genügt es, zwischen 0,1% und 3%, insbesondere zwischen 0,5% und 1,5%, aller Voxel des Musterfeldes als Seed-Positionen auszuwählen, um eine ausreichende Füllung des Musterfeldes mit Glyphenobjekten zu erreichen. Das Verwerfen von Glyphenobjekten, die mit bereits im Musterfeld positionieren anderen Glyphenobjekten überlappen, führt zu einer Verbesserung des Kontrasts des resultierenden Bildes. Ebenfalls erhöht dies die Erkennbarkeit einander kreuzender Nervenfaserbündel.

Die Integrallinien weisen vorzugsweise eine Länge auf, die dem 0,5-bis vierfachen, insbesondere dem 0,8- bis zweifachen, der Auflösung des Voxel-Rasters des Diffusionsdaten-Vektorfeldes entspricht. Im Vergleich zum herkömmlichen Fasertrackingverfahren sind die Integrallinien somit sehr kurz. Hierdurch verringert sich die Gefahr deutlich, dass das Fasertracking in Bereichen kleiner Krümmungsradien bzw. in Bereichen von sich kreuzenden Fasern irregeleitet wird. Die Kontinuität der Darstellung der Nervenfasern ergibt sich aus der Anwendung des erfindungsgemäßen LIC-Verfahrens.

Eine besonders kontrastreiche Darstellung ergibt sich, wenn vorzugsweise Voxel des Musterfeldes, die von keinem Glyphenobjekt überlappt werden, in einer Hintergrundfarbe, insbesondere schwarz, eingefärbt werden und Voxel, die von einem Glyphenobjekt ganz oder teilweise überlappt werden, in einer von der Hintergrundfarbe abweichenden Farbe, insbesondere weiß, oder mit einer dem Überlappungsgrad entsprechenden Zwischenfarbe, insbesondere einer Graustufe, eingefärbt werden. Eine schwarz-weiße Musterfärbung bringt die höchsten Kontraste. Graustufen oder Farbwahlen können das Visualisierungsergebnis unter leichtem Kontrastverlust verbessern und gegebenenfalls realistischer gestalten.

Vorteilhafterweise wird eine räumliche Ausdehnung und/oder eine Einfärbung der Glyphenobjekte proportional zu einer Stärke der lokalen Anisotropie gesetzt, wobei insbesondere eine Helligkeit vom Zentrum eines Glyphenobjekts zum Rand des Glyphenobjekts hin abfällt, wobei insbesondere eine Steilheit des Helligkeitsabfalls umgekehrt proportional von der Stärke der lokalen Anisotropie abhängt. Die Proportionalität kann in beiden Fällen linear oder mit einer anderen, nicht linearen, Funktion eingestellt sein. Die in der ersten Variante verwendete räumliche Ausdehnung der erzeugten Glyphenobjekte, also Länge der Zylinder, Längsausdehnung der Ellipsoiden etc., kann so von der Stärke der lokalen anisotropen Diffusion abhängig gemacht werden. Die zweite Variante bedeutet, die Stärke der anisotropen Diffusion durch eine geeignete Einfärbung der Glyphenobjekte zu codieren. Dabei kann die räumliche Ausdehnung für alle erzeugten Glyphenobjekte konstant gewählt werden oder ebenfalls, wie in der ersten Variante, proportional zur lokalen Anisotropie verändert werden. Bei der Helligkeitscodierung kann eine Grautonskala verwendet werden, wobei die Helligkeit vom Zentrum des Glyphen zum Rand hin in Längsrichtung abfällt. Bei einer schwachen anisotropen Diffusion erfolgt ein rascher Abfall, wohingegen bei einer starken anisotropen Diffusion die Randbereiche des Glyphen noch relativ helle Grautöne aufweisen. Die jeweilige lokale Anisotropie oder räumliche Ausdehnung bzw. Länge wird dann als Parameter für die Steuerung der Steilheit des Abfalls einer Grauwertefunktion benutzt, die für die Einfärbung der multizylindrischen Glyphenobjekte verwendet wird.

Vorzugsweise wird zur Erzeugung eines Ausgabebildes wenigstens ein zweidimensionales Schnittbild entlang einem Schnitt durch das Ausgabefeld erzeugt, wobei insbesondere mehrere räumlich aufeinanderfolgende Schnittbilder übereinander gelegt werden. Ein Schnittbild ist im Rahmen der Erfindung insbesondere die Auswahl einer zweidimensionalen Voxelebene aus dem Ausgabefeld oder die Auswahl einer Anzahl von Voxelschichten aus dem Ausgabefeld, so dass mehr Information in dem Schnittbild enthalten ist, als dies aus einer einzelnen Voxelschicht erlangt werden kann. So können vorzugsweise fünf bis dreißig, insbesondere zehn bis zwanzig, Voxelschichten zu einem Schnittbild vereinigt werden. Dies verlängert auch die dargestellten Linien. Die Schnittbilder können auch in einer schrägen Schnittebene durch das kartesische Voxelraster liegen. Es können auch gekrümmte Schnittflächen durch das kartesische Ausgabefeld gezogen werden, um beispielsweise die Umfangsflächen verschiedener anatomischer Bereiche flach ausgebreitet darzustellen.

In einer vorteilhaften Weiterbildung wird das Ausgabebild als farbkodiertes Schnittbild einem anatomischen Schnittbild, das dieselbe oder eine ähnliche räumliche Lage und Orientierung in einem gemeinsamen Referenzkoordinatensystem aufweist, überlagert, wobei insbesondere eine Grauwerteskala des anatomischen Schnittbildes unverändert bleibt. So kann ein durch den Anwender gewähltes anatomisches Schnittbild mit einem farbkodierten Schnittbild aus dem LIC-Ergebnis überlagert werden, das dieselbe oder annähernd gleiche räumliche Lage und Orientierung in einem gemeinsamen Referenzkoordinatensystem hat. Die Farbüberlagerung der beiden Bilder wird zweckmäßigerweise so gewählt, dass die für den klinischen Betrachter gewohnte Grauwerteskala der anatomischen Schnittbilder erhalten bleibt und nicht durch die Farbe des LIC-Schnittes verfälscht wird. So werden auf dem anatomischen Schnittbild, das die makroskopische Anatomie zeigt, hoch aufgelöste Faserstrukturen in Relation zur Anatomie sichtbar.

Die der Erfindung zugrunde liegende Aufgabe wird auch durch ein Computerprogramm mit Programmcodemitteln gelöst, bei deren Ausführung auf einer Datenverarbeitungsanlage die Verfahrensschritte des zuvor beschriebenen erfindungsgemäßen LIC-basierten Bildgebungsverfahrens ausgeführt werden, sowie durch einen Datenträger mit einem entsprechenden darauf gespeicherten oder geschriebenen Computerprogramm.

Ferner wird die der Erfindung zugrundeliegende Aufgabe auch durch eine Bildgebungsvorrichtung mit einer Datenverarbeitungsanlage zur Verarbeitung von kernspintomographischen Diffusionsdaten und einer Anzeigevorrichtung gelöst, wobei die Datenverarbeitungsanlage ausgebildet ist, ein zuvor beschriebenes, erfindungsgemäßes LIC-basiertes Bildgebungsverfahren auszuführen, insbesondere mittels eines zuvor genannten darin ablaufenden erfindungsgemäßen Computerprogrammes.

In der Bildgebungsvorrichtung ist vorzugsweise eine Vorrichtung zur Aufnahme kernspintomographischer Diffusionsdaten umfasst. Auf der Anzeigevorrichtung wird das Ergebnis des erfindungsgemäßen Bildgebungsverfahrens angezeigt.

Zu dem erfindungsgemäßen Verfahren genannte Merkmale, Vorteile und Eigenschaften gelten auch für die weiteren Erfindungsgegenstände, die mit dem Bildgebungsverfahren zusammenhängen.

Weitere Merkmale der Erfindung werden aus der Beschreibung erfindungsgemäßer Ausführungsformen zusammen mit den Ansprüchen und den beigefügten Zeichnungen ersichtlich. Erfindungsgemäße Ausführungsformen können einzelne Merkmale oder eine Kombination mehrerer Merkmale erfüllen.

Die Erfindung wird nachstehend ohne Beschränkung des allgemeinen Erfindungsgedankens anhand von Ausführungsbeispielen unter Bezugnahme auf die Zeichnungen beschrieben, wobei bezüglich aller im Text nicht näher erläuterten erfindungsgemäßen Einzelheiten ausdrücklich auf die Zeichnungen verwiesen wird. Es zeigen:
- Fig. 1: einen Ablauf eines erfindungsgemäßen LIC-basierten Bildgebungsverfahrens,
- Fig. 2: Darstellungen von Repräsentationen von Glyphenobjekten,
- Fig. 3: Vergleichsdarstellungen von LIC-Bildgebungsverfahren an simulierten Nervenfasersträngen,
- Fig. 4: schematische Darstellungen der Positionierung von Glyphenobjekten,
- Fig. 5: Darstellungen der Abhängigkeit des Verfahrensergebnisses von der Positionierung der Glyphenobjekte,
- Fig. 6: Darstellung der Ergebnisse verschiedener Multi-Kernel LIC-Verfahren,
- Fig. 7: Darstellungen von Überlagerungen von LIC-Schnittbildern verschiedener Stärke und
- Fig. 8: eine Überlagerung eines anatomischen MRT-Bildes mit erfindungsgemäßen LIC-Schnittbildern und
- Fig. 9: Darstellungen von weiteren Repräsentationen von Glyphenobjekten.

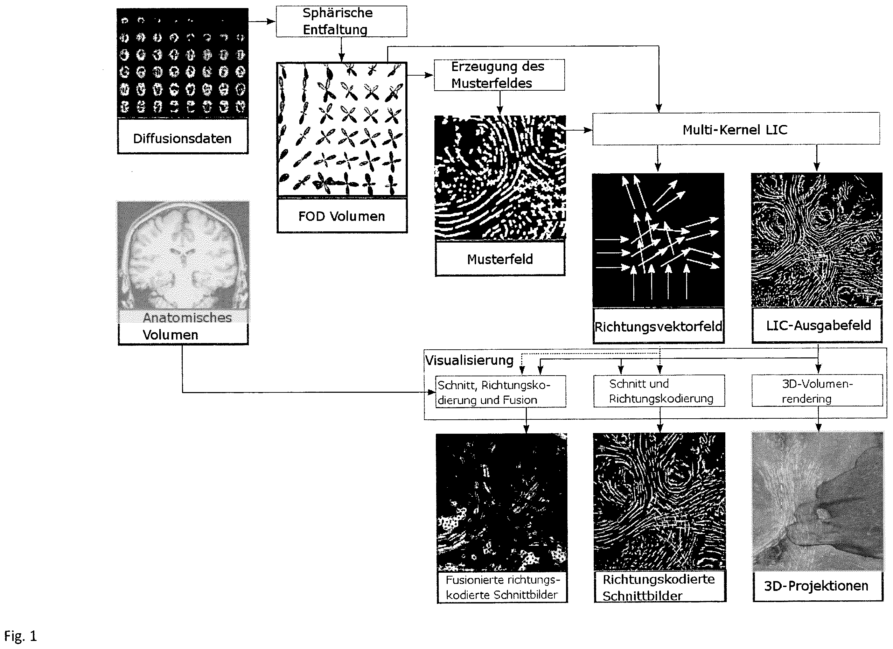

In Figur 1 ist schematisch der Ablauf eines erfindungsgemäßen LICbasierten Bildgebungsverfahrens dargestellt. Ausgangsdaten sind links dargestellt. Es handelt sich dabei zum einen um ein anatomisches Volumen eines Patientengehirns in herkömmlicher MRT-Daten-Darstellung, sowie darüber Schnittdarstellungen durch diffusionsgewichtete MRT-Daten.

Bei dem in Fig. 1 dargestellten Verfahren werden die Diffusionsdaten sphärisch entfaltet. Es ergibt sich daraus ein in Figur 1 als FOD-Volumen bezeichnetes Voxel-Raster mit Richtungsvektorinformationen. Diese sind in Form von FOD-Objekten dargestellt, die einer sphärischen Entfaltung der Diffusionsdaten entstammen. Jedem Voxel des Voxel-Rasters der Diffusionsdaten ist ein entsprechendes FOD-Glyphenobjekt zugeordnet, das in die Hauptrichtungen, also die Richtungen mit den größten Anisotropien eine doppelkeulenförmige linkserstreckte Struktur aufweist. Die Länge der Doppelkeulen entspricht dabei der Stärke der Anisotropie. Wenn eine Anisotropie in verschiedenen Richtungen in einem Voxel vorliegt, ergeben sich multidirektionale FOD-Glyphenobjekte.

Anhand des FOD-Volumens und der darin gespeicherten Richtungsvektordaten wird anschließend ein wesentlich höher aufgelöstes dreidimensionales Musterfeld erzeugt. In Figur 1 wird das Musterfeld, dessen Auflösung beispielsweise das Zwanzigfache der Auflösung des Diffusionsdatenvolumens beträgt, mit schwarzen und weißen Punkten gefüllt. Dabei wird in einem statistischen Verfahren das Musterfeld mit Glyphenobjekten gefüllt, die beispielsweise den Glyphenobjekten aus dem Diffusionsdatenfeld bzw. FOD-Volumen entsprechen, aber kleiner sind als das Voxel-Raster der Diffusionsdaten. Die Rasterung eines Glyphenobjekts erfolgt beispielsweise dadurch, dass alle von einem Glyphenobjekt zu mindestens 50% überdeckten Voxel des Rasters mit der Farbe Weiß gekennzeichnet werden und alle entsprechend nicht besetzten Voxel die Farbe Schwarz erhalten. Es ist auch möglich, anstatt weißer Farbe Grautöne, die den Prozentsatz der Überdeckung des Voxels durch das Glyphenobjekt repräsentieren, zu verwenden. Die Größe eines Glyphenobjekts kann konstant gewählt werden, typischerweise im Bereich von 5 x 5 x 5 bis 10 x 10 x 10 Voxeln des Musterfeldes. Auf diese Weise können bei der Verwendung von mehr Voxeln, also einer höheren Auflösung, komplexere Formen bzw. Diffusionsprofile mit kleineren Kreuzungswinkeln zwischen sich kreuzenden Faserbahnen dargestellt werden.

Da dieses binäre LIC-Eingabemuster primär Faserrichtungsinformationen repräsentieren soll, kann auch auf einfachere GlyphenFormen zurückgegriffen werden. Ein Beispiel dafür ist ein multizylindrisches Glyphenobjekt, bei dem für jede anisotrope Diffusionsrichtung bzw. Faserrichtung ein Zylinder konstruiert wird, dessen Längsachse mit der jeweiligen Faserrichtung zusammenfällt.

Wenn mehrere lokale Maxima in der FOD erkannt werden, überlagern sich die entsprechenden Zylinder zu einem multi-zylindrischen Glyphen-Objekt, das genauso gerastert werden kann, wie das FOD-Oberflächen-Objekt. Weitere Glyphenformen sind etwa die Überlagerung von Ellipsoiden, wobei jede der Ellipsoiden eine anisotrope Diffusionsrichtung in Richtung und Stärke repräsentiert.

Eine Platzierung der Glyphen im Raster der gemessenen Diffusionsdaten würde zu Diskontinuitäten der Faserlinien im LIC-Ergebnis führen. Daher ist es zweckmäßig, Glyphenobjekte in dem hoch aufgelösten Raster zu platzieren, so dass die Platzierung die Kontinuität von Faserverläufen abbildet. Dies wird beispielsweise dadurch erreicht, dass zunächst Seeds im hoch aufgelösten Raster unter Anwendung einer Zufallsstrategie, bei der jeder Raumpunkt gleichwahrscheinlich ist, gesetzt wird und für jedes so gewähltes Seed ein Fasertracking über eine kurze Distanz durchgeführt wird, wobei das Fasertracking zur Richtungsfindung interpolierte FOD verwendet, und Glyphenobjekte auf jeder der berechneten Integrallinien so platziert werden, dass sich eine möglichst dichte Packung von Glyphenobjekten ergibt. Dies erscheint in dem Musterfeld in Figur 1 augenfällig dahin, dass sich Objektreihen in Form von Strichen ergeben.

Die zufällige Platzierung von Seeds wird solange durchgeführt, bis ein gewisser Prozentsatz der Voxel des hoch aufgelösten Datensatzes als Seeds ausgewählt ist. Meistens ist ein Prozentsatz von 1 % ausreichend, um das hoch aufgelöste Raster ausreichend mit Glyphenobjekten zu füllen. Bei dem Trackingverfahren kann ein einfaches deterministisches Tracking angewendet werden, es können aber auch komplexere Verfahren zum Einsatz kommen. Die Richtungsinformation beim Tracking kann aus interpolierten FODs gewonnen werden oder aus anderen, das lokale Diffusionsprofil repräsentierenden Funktionen bzw. Modelldaten. Um kumulative Trackingfehler weitgehend auszuschließen, wird die Anzahl der Iterationen bzw. die Trackingdistanz zweckmäßigerweise gering gewählt. Distanzen in der Größenordnung der Voxellänge des gemessenen Diffusionsdatensatzes, typischerweise 2 bis 3mm, sind im Allgemeinen ausreichend. Für die Platzierung der Glyphenobjekte wird ebenfalls eine Zufallsstrategie angewendet, wobei jedes der von einer Integrallinie berührten Voxel gleich wahrscheinlich ist. Nach Auswahl eines Voxels wird auf der Basis des lokalen Diffusionsprofils ein Glyphenobjekt erzeugt und gerastert. Dabei wird geprüft, ob dieses ein bereits vorhandenes Glyphenobjekt überlappt und gegebenenfalls verworfen.

Nach der Erzeugung des Musterfeldes in Figur 1 erfolgt ein Multi-Kernel-LIC-Verfahren. Zweckmäßigerweise wird ein Verfahren gewählt, das pro Voxel mehrere Richtungen anisotroper Diffusion verfolgen kann. Hierzu zählt ein Verfahren, bei dem in einem ersten Durchlauf ausschließlich die Hauptrichtungen verfolgt werden. Das Ergebnis dieses ersten LIC Durchgangs wird dann als Eingabemuster für einen zweiten LIC Durchlauf verwendet, wobei ausschließlich die zweite anisotrope Diffusionsrichtung verfolgt wird.

Alternativ dazu kann ein LIC Verfahren benutzt werden, das mit einem multiplen Kernel arbeitet. Als Kernel wird die von einem Voxel des Eingabemusters ausgehende Integrallinie, die sich über mehrere benachbarte Voxel erstreckt, verstanden. Bei dem LIC Verfahren mit multiplem Kernel wird das Fasertracking pro Voxel zunächst entlang der Hauptrichtung des im Voxel vorliegenden Diffusionsprofils durchgeführt. Dadurch ergibt sich eine erste Integrallinie, also ein erster Kernel. Danach wird für dasselbe Voxel untersucht, ob eine Nebenrichtung vorliegt. Falls dies der Fall ist, wird ein Fasertracking entlang der Nebenrichtung durchgeführt. Dadurch ergibt sich eine zweite Integrallinie, also ein zweiter Kernel. Es können noch weitere Nebenrichtungen untersucht werden, wobei sich weitere Kernel ergeben. Der erzeugte multiple Kernel, der aus mehreren Integrallinien bestehen kann, wird so verarbeitet, daß die Grauwerte der vom multiplen Kernel überdeckten Punkte des Glyphenmusters gemittelt werden. Alternativ kann die Mittelung über jeden Einzelkernel des multiplen Kernels separat durchgeführt werden und das Maximum der gemittelten Werte als LIC-Ergebnis im Ausgabebild gesetzt werden.

Zusätzlich kann für eine spätere Richtungskodierung von LIC Schnittbildern die mittlere Vektorrichtung über alle verfolgten Richtungen des gesamten Kernels oder des Teilkernels, aus dem das Maximum stammt, berechnet und gespeichert werden. Das Ergebnis dieses Multi-Kernel-LIC-Verfahrens in Form des LIC-Ausgabefelds und des Richtungsvektorfelds mit den gemittelten Richtungen ist in Figur 1 ebenfalls dargestellt.

Es schließt sich ein Visualisierungsschritt an. Dieser kann die Daten des anatomischen Volumens verwenden. Die Visualisierung des LIC Ergebnisses kann im einfachsten Falle als Schnittbild mit Grauwerten erfolgen. Dabei wird ein beliebiger Schnitt durch das hochaufgelöste Raster des LIC-Ergebnisses berechnet und die von der Schnittebene getroffenen Punkte mit ihrem Grauwert dargestellt. Es ist auch möglich, bei der Berechnung eines Schnittbildes mehrere parallele Schnittebenen zu einem Ergebnisbild zu kombinieren, wobei pro Bildpunkt des Ergebnis-Schnittbildes der mittlere Grauwert der entsprechenden Punkte der benachbarten Schnitte oder alternativ der maximale Grauwert bestimmt wird.

Prinzipiell kann das LIC-Verfahren auch zweidimensional durchgeführt werden, wobei von vorneherein nur die Punkte eines definierten Schnittes durch das Datenvolumen berechnet werden. In diesem Fall liegt das Schnittbild unmittelbar als LIC-Ergebnis vor.

Um dem Betrachter Hinweise über die Richtung der anisotropen Diffusion in einem Bildpunkt zu geben, kann zweckmäßigerweise eine richtungsabhängige Farbkodierung des LIC-Ergebnisbildes durchgeführt werden. Dabei werden die im Kernel bestimmten, mittleren Vektorrichtungen genutzt. Beispielsweise kann hierzu das Hue-Saturation-Brightness (HSB) Farbmodell verwendet werden. Dieses spannt einen kegelförmigen Farbraum auf. Der Hue-Kanal bestimmt den Farbton und wird in dem Modell als Rotationswinkel um die zentrale Kegelachse verstanden, wobei von rot (0 bzw. 360 Grad) über grün (120 Grad) und blau (240 Grad) gegangen wird. Der Saturation-Kanal bestimmt die Farbsättigung und wird als Entfernung des Farbpunktes auf der Kegeloberfläche von der Zentralachse des Kegels im Intervall [0,100] aufgefasst. Der Brightness-Kanal definiert die Helligkeit der Farbe und wird auf dem direkten Weg zwischen der Kegelbasis (0 = scharz) und der Spitze (100 = weiß) abgetragen. Der berechnete LIC-Grauton kann nun durch Skalierung in das [0,100] Intervall überführt und als Brightness-Wert gespeichert werden.

Der Farbton (Hue-Kanal) kann beispielsweise wie folgt bestimmt werden: Der Winkel zwischen dem Normalenvektor der Schnittebene und der mittleren Vektorrichtung, die für den einzufärbenden Punkt des LIC-Ergebnisse gespeichert wurde, wird bestimmt und durch Skalierung vom Intervall [0,90] in das Intervall [120,240] gebracht. Dadurch wird erreicht, dass alle Faserlinien, die annährend parallel zur Schnittebene verlaufen, grün eingefärbt werden, während alle Anteile des LIC-Ergebnisses, die Fasern entsprechen, die annähernd senkrecht zur Schnittebene verlaufen, blau eingefärbt werden. Der Saturation-Kanal kann dabei immer auf 100 gesetzt werden. Bei der Skalierung des Farbtons kann alternativ ein anderes Ziel-Intervall verwendet werden, wodurch sich unterschiedliche Farbkontraste für parallel bzw. senkrecht zur Schnittebene orientierte Faseranteile ergibt.

Eine weitere Verbesserung der Visualisierung des LIC-Ergebnisses kann erreicht werden, indem das farbkodierte oder nichtfarbkordierte LIC Schnittbild mit einem entsprechenden anatomischen Schnittbild überlagert wird. Als anatomisches Schnittbild soll ein Schnittbild verstanden werden, das die makroskopische Anatomie zeigt. Ein solches kann gewonnen werden aus Datensätzen der Kernspin-Tomographie oder der Computer-Tomographie, die von demselben Untersuchungsobjekt gewonnen wurden. Beispielsweise werden häufig bei der Aufnahme von kernspin-tomographischen Diffusionsdatensätzen sog. T1- oder T2-gewichtete Datensätze unmittelbar vor oder nach der Diffusionsbildgebung aufgenommen. Voraussetzung für die Überlagerung der Schnittbilder ist es, daß die verwendeten Datensätze in ein gemeinsames Referenzkoordinatensystem übertragen werden bzw. dass eine Transformationsfunktion vorhanden ist, die das Koordinatensystem des einen in das Koordinatensystem des anderen Datensatzes überführt. Die Bestimmung der Transformationsfunktion kann mit bekannten Verfahren der Registrierung von Bildvolumina durchgeführt werden. Danach kann einem Schnitt durch das LIC-Ergebnis ein räumlich entsprechender Schnitt aus dem anatomischen Datensatz mit derselben Lage und Orientierung im Referenzkoordinatensystem zugeordnet werden.

Die farbliche Überlagerung der beiden Schnittbilder kann durch Abwandlung des obigen Farbschemas erreicht werden: Die Grauwerte des anatomischen Schnittbildes werden durch Skalierung in das Intervall [0,100] übertragen und definieren den Wert des Brightness-Kanals des HSB-Farbmodells. Der berechnete LIC-Wert eines Bildpunktes wird in das [0,100] Intervall übertragen und definiert den Wert des Saturation-Kanals. Der Wert des Hue-Kanals wird aus der gemittelten Vektorrichtung wie oben beschrieben bestimmt. Zweckmäßigerweise wird bei der Darstellung des Ergebnisses der Überlagerung auf einem Computermonitor durch geeignete Interaktionsmechanismen der Anwender in die Lage versetzt, die Parmeter der für die Bestimmung der Brighness-Werte erfolgten Skalierung des anatomischen Bildes interaktiv in Echtzeit zu verändern und so Helligkeit und Kontrast des anatomischen Bildes zu variieren. Für die Überlagerung können auch andere Farbmodelle verwendet werden. Vorteilhafterweise erfolgt die Überlagerung so, dass für jeden Bildpunkt des anatomischen Schnittbildes ein räumlich entsprechender Bildpunkt aus dem LIC-Ergebnis zusammen mit diesem dargestellt wird, so daß der Betrachter beide Informationen unmittelbar als Farbsignal wahrnehmen kann.

In Figur 1 sind in der untersten Reihe drei verschiedene mögliche Ergebnisse gezeigt. Links ist ein fusioniertes richtungskodiertes Schnittbild gezeigt, bei dem dem anatomischen Volumen, das in Graustufen dargestellt ist, die Richtungskodierung und der Schnitt durch das LIC-Ausgabefeld des entsprechenden anatomischen Bereichs überlagert ist.

Mittig ist ein richtungskodiertes Schnittbild gezeigt, bei dem die Richtungskodierung in Graustufen gezeigt ist. Rechts ist gezeigt, dass auch ein 3D-Volumenrendering erfolgen kann, bei dem aus dem anatomischen Volumen zusammenhängende Objekte als voluminöse Körper mit Oberflächen dargestellt werden und die Ergebnisse des LIC-Verfahrens aus dem LIC-Ausgabefeld diesen ebenfalls dreidimensional überlagert werden. Es kann sich um beliebige Schnitte oder um eine dreidimensionale Projektion handeln.

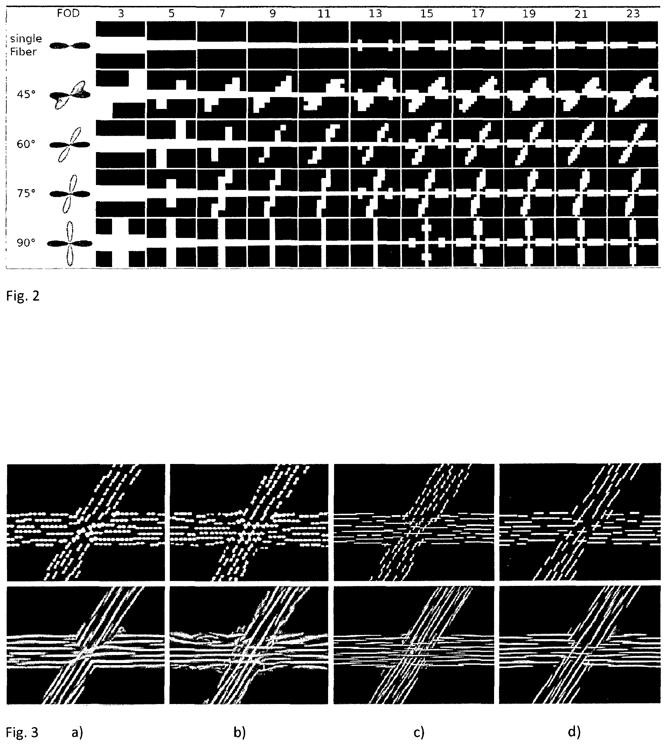

Im Folgenden werden Details des erfindungsgemäßen Verfahrens beispielhaft beleuchtet. In Figur 2 ist die Rasterung von FOD-Oberflächen-Glyphenobjekten in einem Voxel- bzw. Pixel-Raster gezeigt. Von links nach rechts erhöht sich die Auslösung von 3 x 3 Pixeln zu 23 x 23 Pixeln, von oben nach unten ist zunächst eine Reihe für eine einzelne Vorzugsrichtung ("Singlefiber") und darunter für jeweils zwei vorhandene Vorzugsrichtungen in sukzessiv fortschreitenden Schnittwinkeln von 45° bis 90° gezeigt. Es zeigt sich, dass die Auflösung von mehreren Richtungen von einer höheren Auflösung des Rasters profitiert und im Allgemeinen für größere Winkel zwischen den beiden Richtungen besser ist als für kleinere Winkel.

In Figur 3 sind in zwei Zeilen die Musterfelder (oben) und die Ausgabefelder (unten) für Multi-Kernel-LIC-Verfahren dargestellt, wobei in den Figuren 3a), b), c) und d) jeweils verschiedene Glyphenobjekte verwendet werden. In Figur 3 a) handelt es sich bei den Glyphenobjekten um normalisierte Orientation-Distribution Function (ODF). Es zeigt sich in dem unteren Bild in Figur 3a), dass diese unbehandelten ODFs eine unzureichende Auflösung zwischen zwei simulierten Fasersträngen, die sich unter einem 60°-Winkel schneiden, bietet. In Figur 3b) sind die im Musterfeld verwendeten Glyphenobjekte geschärfte ODFs, die eine bessere Richtungsauflösung bieten. Hier ist der Durchstoßbereich im unteren Bild in Figur 3b) bereits deutlicher sichtbar.

In Figur 3c) werden die aus einer sphärischen Entfaltung entstandenen FODs verwendet, während in Figur 3d) multizylindrische Objekte verwendet werden. Es zeigt sich, dass in den letzten beiden Fällen eine gute Darstellung einander durchdringender simulierter Fasern erreicht wird, wobei die Verwendung von multizylindrischen Objekten eine etwas klarere Darstellung bietet. Es hängt vom Anwendungsfall ab, welche der beiden Versionen die besseren Ergebnisse bringt.

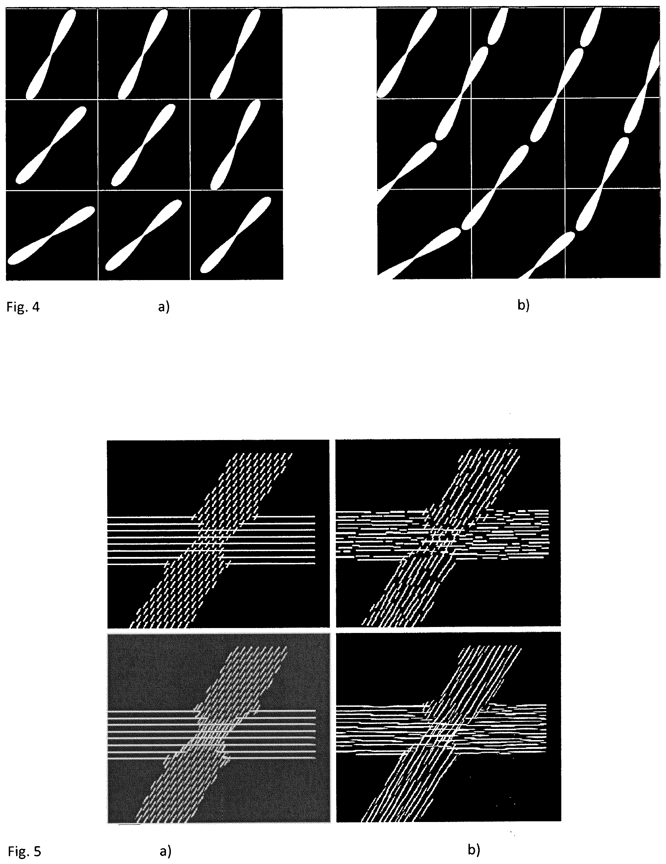

In Figur 4a) und 4b) sind für den Fall von einfachen monodirektionalen FOD-Objekten die Effekte der Positionierung gezeigt. In Figur 4a) sind die Glyphenobjekte jeweils zentral in einem Voxel angeordnet, wobei die Glyphenobjekte, die im Wesentlichen parallel zueinander ausgerichtet sind, nur in wenigen Fällen aneinander anschließen und zu längeren verbundenen Linien führen, während in Figur 4b) die Positionierung der Glyphenobjekte auf zusammenhängenden Integrallinien erfolgt ist und somit bereits in dem entsprechenden Musterfeld die Visualisierung der entsprechenden Nervenfasern angelegt ist.

Der Effekt dieser Auswahl auf ein LIC-Verfahren ist in Figur 5a) und b) dargestellt. Für den wiederrum simulierten Fall zweier sich unter einem Winkel von 60° kreuzender Faserbündel ist in Figur 5a) oben als Seed jeweils das Zentrum eines Voxels des größeren Diffusionsdaten-Raumes mit niedrigerer Auflösung gewählt worden. Die waagerecht verlaufenden Linien sind daher geschlossen. Die unter dem Winkel von 60° laufenden Linien bilden ein regelmäßiges, aber nicht zusammenhängendes Muster. Das darunter gezeigte Ergebnis des Multi-Kernel-LIC-Verfahrens zeigt, dass diese Vorgehensweise zu einer unvollkommenen Visualisierung der Stränge geführt hat. In Figur 5b) ist oben eine Zufallsanordnung mit zufallsausgewählten Seeds gezeigt, von denen aus jeweils entsprechende Integrallinien zur Platzierung weiterer Glyphenobjekte ausgewählt worden waren. Dieses Muster führt in Figur 5b) unten zu einer deutlich besseren Darstellung beider einander durchkreuzender simulierter Nervenstränge. Dies gilt auch für den Kreuzungsbereich selbst.

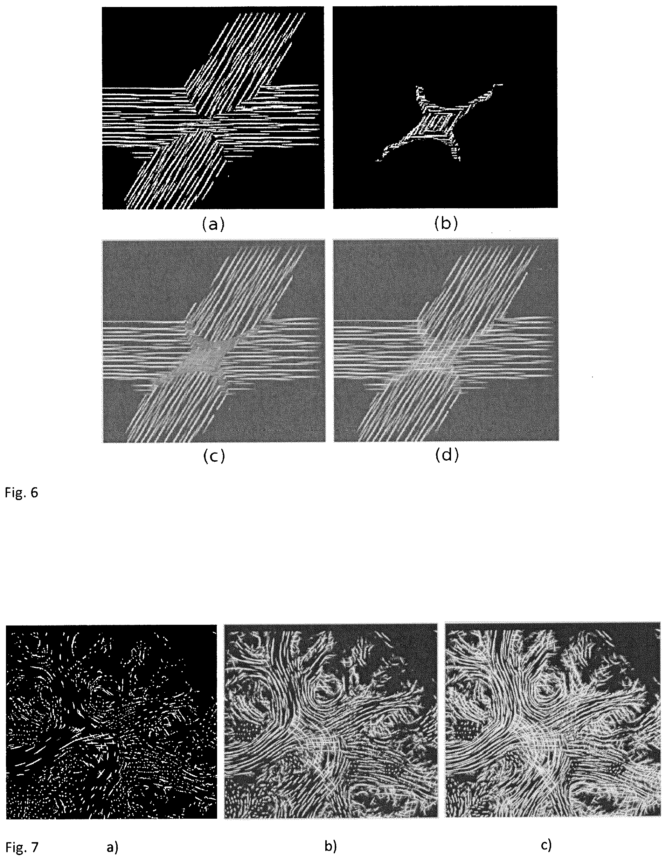

In Figur 6 sind die Ergebnisse zweier unterschiedlicher LIC-Verfahren gezeigt. In Figur 6a) ist das Ergebnis eines ersten Durchgangs eines kumulativen LIC-Verfahrens gezeigt, wobei zunächst nur die Hauptrichtungen integriert wurden. In Figur 6c) ist das in Figur 6a) gezeigte Bild in die zweitstärkste Richtung jeweils weiterentwickelt worden. Es zeigt sich ein vergleichsweise verwaschenes Zentrum. In Figur 6b) ist das Resultat nur des zweiten Durchgangs, also der niederrangigen Richtung, gezeigt. In Figur 6d) ist im Vergleich das Ergebnis eines Multi-Kernel-LICs gezeigt, bei dem die verschiedenen höher- und niederrangigen Richtungen unabhängig voneinander entwickelt worden waren. Dabei war jeweils das Maximum der Signalwerte aus dem ersten und dem zweiten Durchgang bzw. der ersten und der zweiten Richtung pro Pixel für das Ausgabefeld gewählt worden.

Figur 7a) bis c) zeigt das Ergebnis eines Schnittbildes, das sich aus einer einzelnen Voxelschicht des Ausgabefeldes in Figur 7a), einer Aufsummierung von 10 Voxelschichten (Figur 7b) und einer Aufsummierung von 20 Voxelschichten (Figur 7c) des Ausgabefeldes ergeben. Die zunehmende Dicke der ausgewählten Schicht führt zu einer dichteren Besetzung mit Linien, die auch länger in der Schnittebene liegen und daher länger dargestellt sind. Dies führt zu einer verbesserten Wahrnehmbarkeit der Faserverläufe.

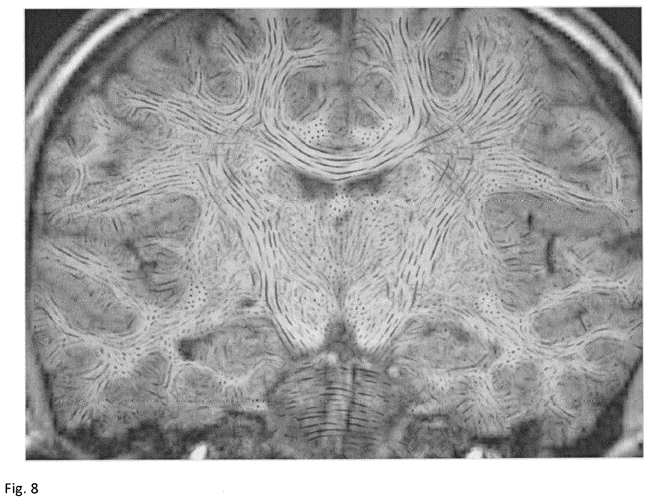

In Figur 8 ist schließlich im Detail das Ergebnis einer Überlagerung eines Schnittbildes durch ein LIC-Ausgabefeld mit dem entsprechenden Schnittbild durch die anatomischen MRT-Daten gezeigt. Es ist deutlich erkennbar, dass die anatomischen Graustufenbilder passend um die Visualisierung der Nervenstrukturen und -richtungen ergänzt ist, wobei solche Nervenstränge, die in der Schnittebene liegen, mit langen Strichen gezeichnet sind, während Nervenstränge, die quer zur Schnittrichtung verlaufen, nur durch Punkte repräsentiert sind. Dies ist eine intuitive und eingängige Visualisierung der anatomischen Gegebenheiten.

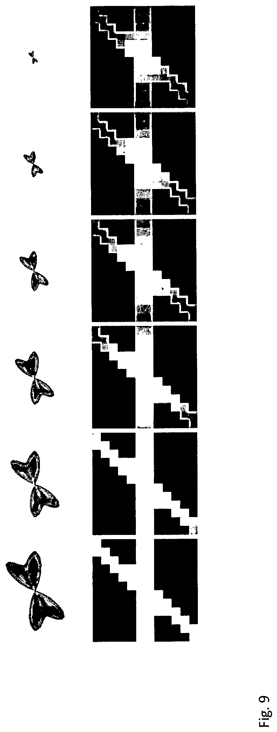

In Fig. 9 wird ein lokales Diffusionsprofil mit einer FOD, die aus den Rohdaten der Diffusionsmessung berechnet wird, beschrieben. Diese FODs sind in der oberen Reihe gezeigt. Die Richtungen maximaler Ausdehnung der FOD entsprechen Richtungen anisotroper Diffusion. In diesem Fall ist in der oberen Reihe die räumliche Ausdehnung der FODs, hier die Längsausdehnung der Ellipsoiden von der Stärke der lokalen anisotropen Diffusion abhängig gemacht, wobei die Stärke von links nach rechts abnimmt, ebenso wie die Größe der FODs. Die jeweilige räumliche Ausdehnung, bzw. Länge, wird dann als Parameter für die Steuerung der Steilheit des Abfalls einer Grauwertefunktion benutzt, die für die Einfärbung der multizylindrischen Glyphenobjekte verwendet wird. Diese werden in der unteren Reihe gezeigt. Hier ist für die gleiche Abnahme der Stärke der lokalen Anisotropie gezeigt, dass die räumliche Ausdehnung für alle erzeugten Glyphenobjekte konstant gewählt und die Stärke der anisotropen Diffusion durch eine geeignete Einfärbung der Glyphenobjekte codiert wird. Es wird eine Grautonskala verwendet, wobei die Helligkeit vom Zentrum des Glyphen zum Rand hin in Längsrichtung abfällt. Bei einer schwachen anisotropen Diffusion (ganz rechts) erfolgt ein rascher Abfall, wohingegen bei einer starken anisotropen Diffusion (ganz links) die Randbereiche des Glyphen noch relativ helle Grautöne aufweisen.

Alle genannten Merkmale, auch die den Zeichnungen allein zu entnehmenden sowie auch einzelne Merkmale, die in Kombination mit anderen Merkmalen offenbart sind, werden allein und in Kombination als erfindungswesentlich angesehen. Erfindungsgemäße Ausführungsformen können durch einzelne Merkmale oder eine Kombination mehrerer Merkmale erfüllt sein. Im Rahmen der Erfindung sind Merkmale, die mit "insbesondere" oder "vorzugsweise" gekennzeichnet sind, als fakultative Merkmale zu verstehen.

## Patentansprüche

1. LIC-basiertes Bildgebungsverfahren für kernspintomographische Diffusionsdaten, die in einem Diffusionsdaten-Vektorfeld mit einem dreidimensionalen Voxel-Raster vorliegen, wobei jedem Voxel ein Diffusionsprofil mit Richtungsvektoren anisotroper Diffusion mit Richtungen zugeordnet ist, in denen die Diffusionsdaten lokal jeweils ein anisotropes Verhalten aufweisen, mit den folgenden Schritten:
a) es wird ein dreidimensionales Musterfeld mit unterschiedlichen Signalwerten erzeugt, dessen Voxel-Raster wenigstens die gleiche oder eine höhere Auflösung als das Voxel-Raster der Diffusionsdaten aufweist,
b) für jedes Voxel eines dreidimensionalen Ausgabefeldes, dessen Voxel-Raster dem Voxel-Raster des Musterfeldes entspricht, wird wenigstens eine Integrallinie berechnet, indem mittels eines Fasertracking-Algorithmus Richtungsvektoren anisotroper Diffusion ausgehend von dem jeweiligen Voxel über eine vorbestimmte Distanz in Vektorrichtung und Vektorgegenrichtung lokal verfolgt werden,
c) die Signalwerte des Musterfeldes der auf der Integrallinie liegenden Punkte werden gewichtet aufsummiert und/oder gemittelt und der daraus resultierende Wert in einen entsprechenden Voxel des dreidimensionalen Ausgabefelds eingetragen,
**dadurch gekennzeichnet, dass** im Schritt a) das Musterfeld mit Glyphenobjekten gefüllt wird, die jeweils Längserstreckungen in eine oder mehrere Richtungen aufweisen, wobei die Richtungen der Längserstreckungen der Glyphenobjekte den Richtungen der Richtungsvektoren der Diffusionsprofile der umliegenden Voxel des Diffusionsdaten-Vektorfelds entsprechen und/oder daraus interpoliert sind.

2. LIC-basiertes Bildgebungsverfahren nach Anspruch 1, **dadurch gekennzeichnet, dass** das Musterfeld und das Ausgabefeld eine die Datenraster-Auflösung, insbesondere um das 10- oder mehrfache, insbesondere das 16- bis 24-fache, übersteigende Musterfeld-Auflösung aufweisen.

3. LIC-basiertes Bildgebungsverfahren nach Anspruch 2, **dadurch gekennzeichnet, dass** die Glyphenobjekte kleiner, insbesondere halb so groß oder weniger, sind als die Größe von Voxeln des Diffusionsdaten-Vektorfelds.

4. LIC-basiertes Bildgebungsverfahren nach einem der Ansprüche 1 bis 3, **dadurch gekennzeichnet, dass** Schritt b) für jedes Voxel für die jeweils höchstrangige Richtung mit der jeweils stärksten lokalen Anisotropie in den Diffusionsdaten und zusätzlich auch für niederrangige Richtungen mit schwächeren lokalen Anisotropien in den Diffusionsdaten durchgeführt wird, sofern dem Voxel mehr als ein Richtungsvektor anisotroper Diffusion zugeordnet ist.

5. LIC-basiertes Bildgebungsverfahren nach Anspruch 4, **dadurch gekennzeichnet, dass**, sofern einem Voxel mehr als ein Richtungsvektor anisotroper Diffusion zugeordnet ist, die Integrationsschritte in Schritt b) für die Integrallinien in den verschiedenen Richtungen
(1) kumulativ nacheinander erfolgen, wobei jede nachfolgende Integration in einer niederrangigen Richtung auf das im Ausgabefeld eingetragene Ergebnis der vorigen Integration erfolgt, oder
(2) unabhängig voneinander auf jeweils das gleiche anfängliche Musterfeld angewandt werden, wobei für die in das Ausgabefeld einzutragenden Werte die Ergebnisse für die unabhängig voneinander erfolgten Integrationsschritte gemittelt werden oder ein Maximalwert oder ein Minimalwert aus den Ergebnissen eingetragen wird.

6. LIC-basiertes Bildgebungsverfahren nach einem der Ansprüche 1 bis 5, **dadurch gekennzeichnet, dass** die Glyphenobjekte zylindrisch, multizylindrisch oder mono- oder multidirektional doppelkeulenförmig sind.

7. LIC-basiertes Bildgebungsverfahren nach einem der Ansprüche 1 bis 6, **dadurch gekennzeichnet, dass** in Schritt a) die Glyphenobjekte im Musterfeld ausgehend von zufällig ausgewählten oder nach einem Schema bestimmten Seed-Positionen positioniert werden, wobei weitere Glyphenobjekte auf oder nahe bei Integrallinien positioniert werden, die von den Seed-Positionen ausgehen, wobei insbesondere ein Glyphenobjekt verworfen wird, wenn es mit einem bereits im Musterfeld positionierten anderen Glyphenobjekt überlappt.

8. LIC-basiertes Bildgebungsverfahren nach einem der Ansprüche 1 bis 7, **dadurch gekennzeichnet, dass** die Integrallinien eine Gesamtlänge aufweisen, die dem 0,5- bis vierfachen, insbesondere dem 0,8- bis zweifachen, der Auflösung des Voxel-Rasters des Diffusionsdaten-Vektorfeldes entspricht.

9. LIC-basiertes Bildgebungsverfahren nach einem der Ansprüche 1 bis 8, **dadurch gekennzeichnet, dass** Voxel des Musterfeldes, die von keinem Glyphenobjekt überlappt werden, in einer Hintergrundfarbe, insbesondere schwarz, eingefärbt werden und Voxel, die von einem Glyphenobjekt ganz oder teilweise überlappt werden, in einer von der Hintergrundfarbe abweichenden Farbe, insbesondere weiß, oder mit einer dem Überlappungsgrad entsprechenden Zwischenfarbe, insbesondere einer Graustufe, eingefärbt werden.

10. LIC-basiertes Bildgebungsverfahren nach einem der Ansprüche 1 bis 9, **dadurch gekennzeichnet, dass** eine räumliche Ausdehnung und/oder eine Einfärbung der Glyphenobjekte proportional zu einer Stärke der lokalen Anisotropie gesetzt wird, wobei insbesondere eine Helligkeit vom Zentrum eines Glyphenobjekts zum Rand des Glyphenobjekts hin abfällt, wobei insbesondere eine Steilheit des Helligkeitsabfalls umgekehrt proportional von der Stärke der lokalen Anisotropie abhängt.

11. LIC-basiertes Bildgebungsverfahren nach einem der Ansprüche 1 bis 10, **dadurch gekennzeichnet, dass** zur Erzeugung eines Ausgabebildes wenigstens ein zweidimensionales Schnittbild entlang einem Schnitt durch das Ausgabefeld erzeugt wird, wobei insbesondere mehrere räumlich aufeinanderfolgende Schnittbilder übereinander gelegt werden.

12. LIC-basiertes Bildgebungsverfahren nach Anspruch 11, **dadurch gekennzeichnet, dass** das Ausgabebild als farbkodiertes Schnittbild einem anatomischen Schnittbild, das dieselbe oder eine ähnliche räumliche Lage und Orientierung in einem gemeinsamen Referenzkoordinatensystem aufweist, überlagert wird, wobei insbesondere eine Grauwerteskala des anatomischen Schnittbildes unverändert bleibt.

13. Computerprogramm mit Programmcodemitteln, bei deren Ausführung auf einer Datenverarbeitungsanlage die Verfahrensschritte des LIC-basierten Bildgebungsverfahrens nach einem der Ansprüche 1 bis 12 ausgeführt werden.

14. Datenträger mit einem darauf gespeicherten oder geschriebenen Computerprogramm nach Anspruch 13.

15. Bildgebungsvorrichtung mit einer Datenverarbeitungsanlage zur Verarbeitung von kernspintomographischen Diffusionsdaten und einer Anzeigevorrichtung, wobei die Datenverarbeitungsanlage ausgebildet ist, ein LIC-basiertes Bildgebungsverfahren nach einem der Ansprüche 1 bis 12 auszuführen, insbesondere mittels eines darin ablaufenden Computerprogramms nach Anspruch 12, wobei die Bildgebungsvorrichtung insbesondere eine Vorrichtung zur Aufnahme kernspintomographischer Diffusionsdaten umfasst.

## Claims

1. An LIC-based imaging method for MRI diffusion data that are provided in a diffusion data vector field with a three-dimensional voxel raster, wherein each voxel is assigned a diffusion profile with direction vectors of anisotropic diffusion with directions in which the diffusion data each have locally anisotropic behavior, comprising the following steps:
a) a three-dimensional sample field with different signal values is generated the voxel raster of which has the same or a greater resolution than the voxel raster of the diffusion data,
b) for each voxel of a three-dimensional output field with a voxel raster that corresponds to the voxel raster of the sample field, at least one integral line is calculated by locally tracking direction vectors of anisotropic diffusion with a fiber tracking algorithm starting from the respective voxel over a set distance in the direction of the vector and the direction opposite the vector,
c) the signal values of the sample field of the points lying on the integral line are summed weighted and/or averaged, and the resulting value is entered in a corresponding voxel of the three-dimensional output field,
**characterized in that** in step a), the sample field is filled with glyph objects that each have longitudinal extensions in one or several directions, wherein the directions of the longitudinal extensions of the glyph objects correspond to the directions of the direction vectors of the diffusion profiles of the surrounding voxels of the diffusion data vector field, and/or are interpolated therefrom.

2. The LIC-based imaging method according to claim 1, **characterized in that** the sample field and the output field have a sample field resolution greater than the data raster resolution, in particular by 10 times or more, in particular by 16 to 24 times.

3. The LIC-based imaging method according to claim 2, **characterized in that** the glyph objects are less than, in particular half as large or less, than the size of the voxels of the diffusion data vector field.

4. The LIC-based imaging method according to one of claims 1 to 3, **characterized in that** step b) is performed for each voxel for the highest ranking direction with the strongest local anisotropy in the diffusion data, and in addition also for lower-ranking directions with weaker local anisotropies in the diffusion data if the voxel is assigned more than one direction vector of anisotropic diffusion.

5. The LIC-based imaging method according to claim 4, **characterized in that**, if a voxel is assigned more than one direction vector of anisotropic diffusion, the integration steps in step b) for the integral lines in the different directions
(1) are performed cumulatively in sequence, wherein each sequential integration in a lower-ranking direction is carried out for the result of the previous integration entered in the output field, or
(2) are applied independent of each other to the same initial sample field, wherein the results for the independently performed integration steps are averaged for the values to be entered in the output field, or a maximum value or minimum value from the results is entered.

6. The LIC-based imaging method according to one of claims 1 to 5, **characterized in that** the glyph objects are cylindrical, multicylindrical, or mono- or multidirectionally double-lobed.

7. The LIC-based imaging method according to one of claims 1 to 6, **characterized in that** in step a), the glyph objects are positioned in the sample field starting from seed positions that are randomly selected or determined according to a pattern, wherein additional glyph objects are positioned on or adjacent to integral lines that proceed from the seed positions, wherein in particular a glyph object is rejected when it overlaps with another glyph object already positioned in the sample field.

8. The LIC-based imaging method according to one of claims 1 to 7, **characterized in that** the integral lines have an overall length that corresponds to 0.5 to 4 times, in particular 0.8 to 2 times, the resolution of the voxel raster of the diffusion data vector field.

9. The LIC-based imaging method according to one of claims 1 to 8, **characterized in that** voxels of the sample field that are not overlapped by any glyph objects are colored in a background color, in particular black, and voxels that are entirely or partially overlapped by a glyph object are colored in a color deviating from the background color, in particular white, or with an intermediate color corresponding to the degree of overlap, in particular, a grayscale.

10. The LIC-based imaging method according to one of claims 1 to 9, **characterized in that** a spatial extension and/or a coloring of the glyphs objects is set proportional to a strength of the local anisotropy, wherein in particular a brightness decreases from the center of a glyph object to the edge of the glyph object, wherein in particular a steepness of the decrease in brightness is dependent in reverse proportion on the strength of the local anisotropy.

11. The LIC-based imaging method according to one of claims 1 to 10, **characterized in that** in order to generate an output image, at least one two-dimensional sectional image is generated along a section through the output field, wherein in particular a plurality of spatially sequential sectional images are superimposed.

12. The LIC-based imaging method according to claim 11, **characterized in that** the output image is superimposed as a color-coded sectional image on an anatomical sectional image that has the same or similar spatial position and orientation in a common reference coordinate system, wherein in particular a grayscale of the anatomical sectional image remains unchanged.

13. A computer program with program code means, during the execution of which on a data processing system, the method steps of the LIC-based imaging method according to one of claims 1 to 12 are executed.

14. A data carrier with a computer program according to claim 13 saved or written thereupon.

15. An imaging apparatus with a data processing system for processing MRI diffusion data and a display apparatus, wherein the data processing system is configured to execute an LIC-based imaging method according to one claims 1 to 12, in particular by means of a computer program according to claim 12 running thereupon, wherein the imaging apparatus comprises in particular an apparatus for recording MRI diffusion data.

## Revendications

1. Procédé d'imagerie basé sur LIC pour des données de diffusion de résonance magnétique nucléaire, qui existent dans un champ vectoriel de données de diffusion avec une trame de voxels tridimensionnelle, dans lequel, à chaque voxel correspond un profil de diffusion avec des vecteurs de direction de diffusion anisotrope avec des directions dans lesquelles les données de diffusion présentent chacune un comportement anisotrope, ayant les étapes suivantes :
a) un champ modèle tridimensionnel avec différentes valeurs de signaux est généré, dont le trame de voxels présente au moins la même résolution ou une résolution supérieure à celle de la trame de voxels des données de diffusion,
b) pour chaque voxel, un champ d'émission tridimensionnel, dont la trame de voxels correspond à la trame de voxels du champ modèle, au moins une ligne intégrale est calculée, en poursuivant localement, au moyen d'un algorithme de suivi de faser, des vecteurs de direction d'une diffusion anisotrope, à partir du voxel correspondant, sur une distance prédéterminée dans la direction du vecteur et la direction opposée au vecteur,
c) les valeurs des signaux du champ modèle des points se trouvant sur la ligne intégrale sont additionnées et/ou moyennées de manière pondérée et la valeur qui en résulte est entrée dans un voxel correspondant du champ d'émission tridimensionnel,
**caractérisé en ce que**, à l'étape a), le champ modèle est rempli d'objets de type glyphes qui présentent chacun des extensions longitudinales dans une ou plusieurs directions, les directions des extensions longitudinales des objets de type glyphes correspondant aux directions des vecteurs de direction des profils de diffusion et des voxels environnants du champ vectoriel de données de diffusion et/ou étant interpolées à partir de celles-ci.

2. Procédé d'imagerie basé sur LIC selon la revendication 1, **caractérisé en ce que** le champ modèle et le champ d'émission présentent une résolution de trame de données, plus particulièrement environ 10 fois ou plus, plus particulièrement de 16 à 24 fois supérieure à la résolution du champ modèle.

3. Procédé d'imagerie basé sur LIC selon la revendication 2, **caractérisé en ce que** les objets de type glyphes sont plus petits, plus particulièrement d'une taille représentant la moitié ou moins de la taille des voxels du champ vectoriel de données de diffusion.

4. Procédé d'imagerie basé sur LIC selon l'une des revendications 1 à 3, **caractérisé en ce que** l'étape b) est effectuée, pour chaque voxel, pour la direction présentant la plus haute priorité avec l'anisotropie locale la plus élevée dans les données de diffusion et en outre également pour les directions présentant une priorité basse avec des anisotropies locales plus faibles dans les données de diffusion, si plusieurs vecteurs de direction de diffusion anisotrope sont attribués au voxel.

5. Procédé d'imagerie basé sur LIC selon la revendication 4, **caractérisé en ce que**, si plusieurs vecteurs de direction de diffusion anisotrope sont attribués à un voxel, les étapes d'intégration dans l'étape b) pour les lignes d'intégration dans les différentes directions
(1) ont lieu de manière cumulative, chaque intégration suivante ayant lieu dans une direction de basse priorité sur le résultat, entré dans le champ d'émission, de l'intégration précédente, ou
(2) sont appliquées indépendamment entre elles au même champ modèle initial, moyennant quoi, pour les valeurs à entrer dans le champ d'émission, les résultats pour les étapes d'intégration exécutées indépendamment les unes des autres étant moyennés ou une valeur maximale ou une valeur minimale parmi les résultats étant entrée.

6. Procédé d'imagerie basé sur LIC selon l'une des revendications 1 à 5, **caractérisé en ce que** les objets de type glyphes sont cylindriques, multicylindriques ou ont une forme en double massue mono- ou multidirectionnelle(s).

7. Procédé d'imagerie basé sur LIC selon l'une des revendications 1 à 6, **caractérisé en ce que**, dans l'étape a), les objets de type glyphes sont positionnés dans le champ modèle de positions d'amorces sélectionnées aléatoirement ou déterminées selon un schéma, d'autres objets de type glyphes étant positionnés sur ou à proximité de lignes intégrales qui partent des positions d'amorces, plus particulièrement un objet de type glyphe étant rejeté lorsqu'il se superpose avec un autre objet de type glyphe déjà positionné dans le champ modèle.

8. Procédé d'imagerie basé sur LIC selon l'une des revendications 1 à 7, **caractérisé en ce que** les lignes intégrales présentent une longueur totale qui représente de 0,5 à quatre fois, plus particulièrement de 0,8 à deux fois, la résolution de la trame de voxels du champ vectoriel de données de diffusion.

9. Procédé d'imagerie basé sur LIC selon l'une des revendications 1 à 8, **caractérisé en ce que** les voxels du champ modèle, qui ne sont superposés avec aucun objet de type glyphe, sont colorés avec une couleur d'arrière-plan, plus particulièrement du noir, et les voxels qui sont superposés entièrement ou partiellement avec un objet de type glyphe, sont colorés avec une couleur différente de la couleur d'arrière-plan, plus particulièrement du blanc, ou avec une couleur intermédiaire correspondant au degré de superposition, plus particulièrement un niveau de gris.

10. Procédé d'imagerie basé sur LIC selon l'une des revendications 1 à 9, **caractérisé en ce qu'**une extension spatiale et/ou une coloration des objets de type glyphes sont ajustées proportionnellement à une intensité de l'anisotropie locale, plus particulièrement une luminosité diminuant du centre d'un objet de type glyphe vers le bord de l'objet de type glyphe, plus particulièrement une pente de diminution de la luminosité dépendant de manière inversement proportionnelle de l'intensité de l'anisotropie locale.

11. Procédé d'imagerie basé sur LIC selon l'une des revendications 1 à 10, **caractérisé en ce que**, pour la génération d'une image de sortie, au moins une image de coupe bidimensionnelle le long d'une coupe à travers le champ de sortie, moyennant quoi plusieurs images de coupe successives sont superposées dans l'espace.

12. Procédé d'imagerie basé sur LIC selon la revendication 11, **caractérisé en ce que** l'image de sortie est superposée, en tant qu'image de coupe à code couleur, à une image de coupe anatomique, qui présente la même position et orientation ou une position et orientation spatiale similaire dans un système de coordonnées de référence commun, moyennant quoi une échelle de niveaux de gris de l'image de coupe anatomique reste inchangée.

13. Programme informatique avec des moyens formant code de programme, qui, lors de leur exécution sur une installation de traitement de données, exécutent les étapes de procédé du procédé d'imagerie basée sur LIC selon l'une des revendications 1 à 12.

14. Support de données, sur lequel est enregistré ou inscrit un programme informatique selon la revendication 13.

15. Dispositif d'imagerie avec une installation de traitement de données pour le traitement de données de diffusion de résonance magnétique nucléaire et un dispositif d'affichage, dans lequel l'installation de traitement de données est conçue pour exécuter un procédé d'imagerie basé sur LIC selon l'une des revendications 1 à 12, plus particulièrement au moyen d'un programme informatique exécuté dans celle-ci, selon la revendication 12, le dispositif d'imagerie comprenant plus particulièrement un dispositif pour l'enregistrement de données de diffusion de résonance magnétique nucléaire.
